(19) Europäisches Patentamt
European Patent Office
Office européen des brevets

(11) **EP 3 038 084 B1**

(12) **EUROPEAN PATENT SPECIFICATION**

(45) Date of publication and mention of the grant of the patent:
**13.03.2019 Bulletin 2019/11**

(51) Int Cl.:
**G09G 3/20** *(2006.01)*    **G09G 3/32** *(2016.01)*

(21) Application number: **15200003.0**

(22) Date of filing: **15.12.2015**

(54) **DISPLAY DEVICE AND SELF-CALIBRATION METHOD THEREOF**

ANZEIGEVORRICHTUNG UND SELBSTKALIBRIERUNGSVERFAHREN DAFÜR

DISPOSITIF D'AFFICHAGE ET SON PROCÉDÉ D'AUTO-ÉTALONNAGE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.12.2014 KR 20140190752**

(43) Date of publication of application:
**29.06.2016 Bulletin 2016/26**

(73) Proprietor: **LG Display Co., Ltd.**
**Seoul 07336 (KR)**

(72) Inventors:
• **PARK, Dongwon**
  **Gyeonggi-do (KR)**
• **KWON, Yongchul**
  **136-073 Seoul (KR)**

(74) Representative: **Ter Meer Steinmeister & Partner**
**Patentanwälte mbB**
**Nymphenburger Straße 4**
**80335 München (DE)**

(56) References cited:
JP-A- 2011 158 821     US-A1- 2003 122 813
US-A1- 2003 201 727     US-A1- 2011 089 853

## Description

This application claims the benefit of Korean Patent Application No. 10-2014-0190752 filed on December 26, 2014.

### Field of the Invention

Embodiments of the invention relate to a display device and a self-calibration method thereof.

### Discussion of the Related Art

Various flat panel displays such as a liquid crystal display (LCD), an organic light emitting diode (OLED) display, a plasma display panel (PDP), and a field emission display (FED) haven been used.

The liquid crystal display displays an image by controlling an electric field applied to liquid crystal molecules based on a data voltage. An active matrix liquid crystal display reduces the manufacturing cost and improves a performance due to the development of process technology and driving technology. Hence, the active matrix liquid crystal display is applied to almost all of display devices from a small-sized mobile device to a large-sized television and has been widely used.

Because the OLED display is a self-emission display device, the OLED display may be manufactured to have lower power consumption and thinner profile than the liquid crystal display requiring a backlight unit. Further, because the OLED display has advantages of a wide viewing angle and a fast response time, the OLED display has expanded its market while competing with the liquid crystal display.

The OLED display is driven through a voltage driving method or a digital driving method and may represent gray levels of an input image. The voltage driving method adjusts a data voltage applied to pixels depending on gray levels of data of the input image and adjusts a luminance of the pixels depending on a magnitude of the data voltage, thereby representing the gray levels of the input image. The digital driving method controls emission times of pixels depending on gray levels of data of the input image and represents the gray levels of the input image.

The digital driving method time-divides one frame period into a plurality of subframe periods. Emission times of the subframe periods are set to be different from one another. In the digital driving method, the subframe periods are generally configured so that the emission time of the subframe period at each gray level linearly increases without considering on/off characteristics of the pixel. Because the digital driving method neglects an undesired luminance appearing in the real on/off characteristics of the pixel and simply sets the emission time of the subframe period in proportion to the gray level, a luminance error is generated. Even a luminance reversal phenomenon between the gray levels may be generated. The luminance error or the luminance reversal phenomenon may be differently generated in display panels and thus cannot be uniformly compensated for the display panels.

US 2003/0122813 A1 relates to a display panel driving device and driving method. The value of the light-emission drive current flowing when causing each light-emission elements bearing each pixel to independently emit light in succession is measured, then the luminance is corrected for each input pixel data based on the above light-emission drive current values, associated with the pixels corresponding to the input pixel data.

US 2003/0201727 A1 relates to providing a correcting circuit for correcting a video signal supplied to each pixel to a light emitting device. The correcting circuit is stored with data of a dispersion of a characteristic of a driving TFT among pixels and data of a change over time of luminance of a light emitting element.

JP 2011 158821 A relates to providing a compensation period, in which a connection point between an OLED and a lighting switch is connected to a compensation power source circuit.

US 2011/0089853 A1 relates to including a switchable inductance circuit and a controller to connect an inductance between a power source and an OLED during a startup period as power is first applied to the OLED.

### SUMMARY OF THE INVENTION

The invention is indicated in the independent claims.

Further embodiments are indicated in the dependent claims. Embodiments of the invention provide a display device and a self-calibration method thereof capable of compensating itself for a luminance error generated when pixels are turned on or off.

In one aspect, there is a display device comprising a measurement unit configured to measure a current of a pixel, a luminance error calculation unit configured to calculate a rush current of the pixel emitting light at a measured current value of the pixel and calculate a luminance error of the pixel based on the rush current, and a luminance error compensation unit configured to reduce an emission time of the subframe period or change the turned-on subframe period to compensate the luminance error of the pixel.

Preferably, the luminance error compensation unit is adapted to reduce an emission time of a subframe period, to which least significant bit (LSB) of data to be written on the pixel will be mapped.

Preferably the luminance error compensation unit is adapted to switch between values of gray levels of data at gray levels, in which a luminance reversal is generated due to the luminance error of the pixel.

Preferably the measurement unit is adapted to measure at least one of a current, as a minimum switching current Imin, when a minimum number of switching operations of the pixel is generated in one frame period, and a current, as a maximum switching current (Imax), when a maximum number of switching operations of the pixel is generated in one frame period.

Preferably, the luminance error calculation unit is adapted to calculate an average value Ix_avg of the rush current Ix based on the minimum switching current Imin and the maximum switching current Imax and to calculate the luminance error of the pixel based on the average value of the rush current.

Preferably the pixel includes an organic light emitting diode.

Preferably the display device includes a time controller adapted to control the display panel driver through the digital driving method and is adapted to divide one frame period into a plurality of subframe periods.

Preferably, for driving the display device in the digital driving method, the time controller is adapted to control the emission times of sub frame periods depending on the data of the input image.

Preferably, the measurement unit includes a luminance sensor or a current sensor for measuring the luminance or current of a pixel respectively.

Preferably, the measurement unit is adapted to measure current of one or more pixels located on a display area of the display panel and/or is adapted to measure a current of one or more pixels located in a non-display area of the display panel.

Preferably, the measurement, calculation and compensation of the luminance error are performed during a power-on sequence immediately after the display device is powered on, and/or during a power-off sequence immediately after the display device is powered off.

Preferably, the measurement unit is adapted to measure the luminance or the current of the pixel in a vertical blank period, between two successively arranged frames, in which data is not input, and measure the luminance or the current of the pixel at previously set time intervals.

In another aspect, there is a self-calibration method of a display device comprising measuring a current of a pixel, calculating a rush current of the pixel emitting light at a measured current value of the pixel and calculating a luminance error of the pixel based on the rush current, and reducing an emission time of the subframe period or changing the turned-on subframe period to compensate the luminance error of the pixel.

Preferably, the compensating for the luminance error of the pixel includes reducing an emission time of a subframe period, to which least significant bit (LSB) of data to be written on the pixel will be mapped.

Preferably, the compensating for the luminance error of the pixel includes switching between values of gray levels of data at gray levels, in which a luminance reversal is generated due to the luminance error of the pixel.

## BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:

FIG. 1 is a block diagram of a display device according to an exemplary embodiment of the invention;
FIG. 2 is a circuit diagram of a pixel of the display device shown in FIG. 1;
FIG. 3 shows a measurement unit, a luminance error calculation unit, a luminance error compensation unit according to an exemplary embodiment of the invention;
FIG. 4 is a flowchart showing a self-calibration method of a display device according to an exemplary embodiment of the invention;
FIG. 5 shows an example of a method for arranging subframes;
FIG. 6 shows a method for mapping data to subframes in a subframe arrangement method shown in FIG. 5;
FIG. 7 shows an example where a luminance error of a pixel occurs due to a rush current of the pixel;
FIGS. 8 and 9 show a method for measuring a current of a pixel;
FIG. 10 shows an example of a current measuring method of a pixel and a calculating method of a luminance error;
FIG. 11 shows an example of a remapping method of subframes; and
FIG. 12 shows the result of a compensation for a luminance error using a self-calibration method according to an exemplary embodiment of the invention.

## DETAILED DESCRIPTION OF THE EMBODIMENTS

Reference will now be made in detail to embodiments of the invention, examples of which are illustrated in the accompanying drawings. Wherever possible, the same reference numbers will be used throughout the drawings to refer to the same or like parts. It will be paid attention that detailed description of known arts will be omitted if it is determined that the arts can mislead the embodiments of the invention.

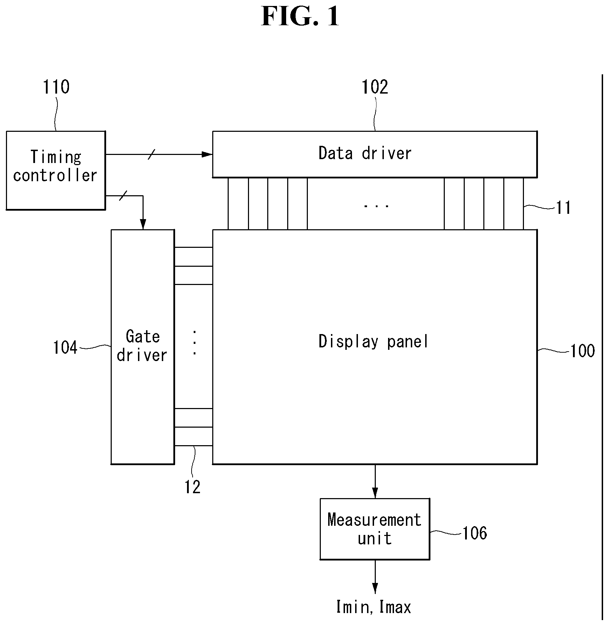

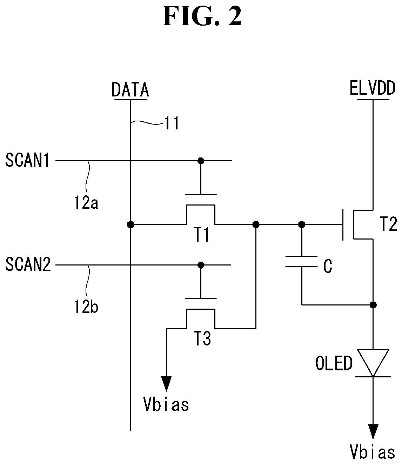

FIGS. 1 and 2 show a display device according to an exemplary embodiment of the invention.

Referring to FIGS. 1 and 2, the display device according to the embodiment of the invention includes a display panel 100, a display panel driver writing pixel data of an input image on a pixel array of the display panel 100, a measurement unit 106 measuring a current of a pixel, and a timing controller 110 controlling the display panel driver.

In the pixel array of the display panel 100, a plurality of data lines 11 and a plurality of scan lines (or gate lines) 12 cross each other. The pixel array of the display panel 100 includes pixels that are arranged in a matrix form and display an input image. Each pixel includes a red subpixel, a green subpixel, and a blue subpixel. Each pixel may further include a white subpixel. As shown in FIG. 2, each pixel may include a plurality of thin film transistors (TFTs), an organic light emitting diode (OLED), a capacitor, and the like.

The display panel driver includes a data driver 102 and a gate driver 104.

The data driver 102 converts data of the input image received from the timing controller 110 into a data voltage and outputs the data voltage to the data lines 11. In a digital driving method, amounts of light emitted by the pixels are the same as one another, and gray levels of the data of the input image are represented based on an emission time of the pixel. Therefore, the data driver 102 selects one of a voltage of a condition where the pixel emits light and a voltage of a condition where the pixel does not emit light depending on a digital value of data mapped to a subframe and generates the selected data voltage.

The gate driver 104 sequentially supplies a scan pulse (or a gate pulse) synchronized with an output voltage of the data driver 102 to first scan lines 12a under the control of the timing controller 110. The gate driver 104 sequentially shifts the scan pulse and sequentially selects the pixels, to which data is applied, on a per line basis. The gate driver 104 sequentially supplies an erase pulse to second scan lines 12b under the control of the timing controller 110. The pixels stop emitting light in response to the erase pulse. The timing controller 110 controls timing of the erase pulse and controls the emission time of the pixel in each subframe.

The measurement unit 106 measures a luminance or a current of the pixel using a light sensor or a current sensor and transmits the result of a measurement to the timing controller 110. In the embodiment disclosed herein, the pixel, of which the luminance or the current is measured, may be a pixel of the pixel array, on which the input image is reproduced, or a dummy pixel disposed in a non-display area of the display panel 100. The light sensor or a current sensor can be implemented as an extra sensor in an pixel area or in dummy pixels. Thus, the extra sensor can be stressed instead of active pixels to avoid emission or leakage of light during measurement.

The timing controller 110 receives the pixel data of the input image and timing signals synchronized with the pixel data of the input image from a host system (not shown). The timing controller 110 controls operation timings of the data driver 102 and the gate driver 104 based on the timing signals input in synchronization with the pixel data of the input image and synchronizes the data driver 102 with the gate driver 104. The timing signals includes a vertical sync signal Vsync, a horizontal sync signal Hsync, a data enable signal DE, and the like.

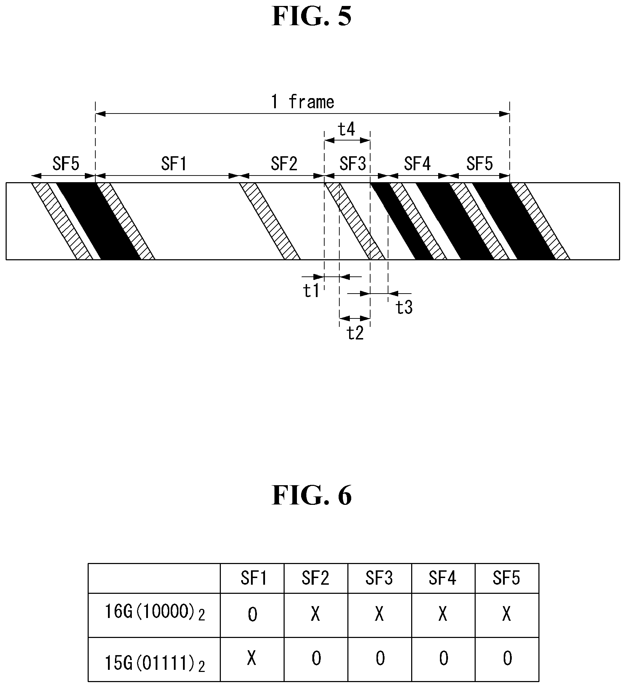

The timing controller 110 controls the display panel driver through the digital driving method. The timing controller 110 divides one frame period into a plurality of subframe periods. As shown in FIG. 5, emission times of subframe periods may be set to be different from one another depending on data bit of the input image. Because the most significant bit (MSB) represents a high gray level, the MSB is mapped to a subframe having a long emission time. Because the least significant bit (LSB) represents a low gray level, the LSB is mapped to a subframe having a short emission time. The timing controller 110 maps data of the input image to the subframe on a per bit basis and transmits the mapped data to the data driver 102.

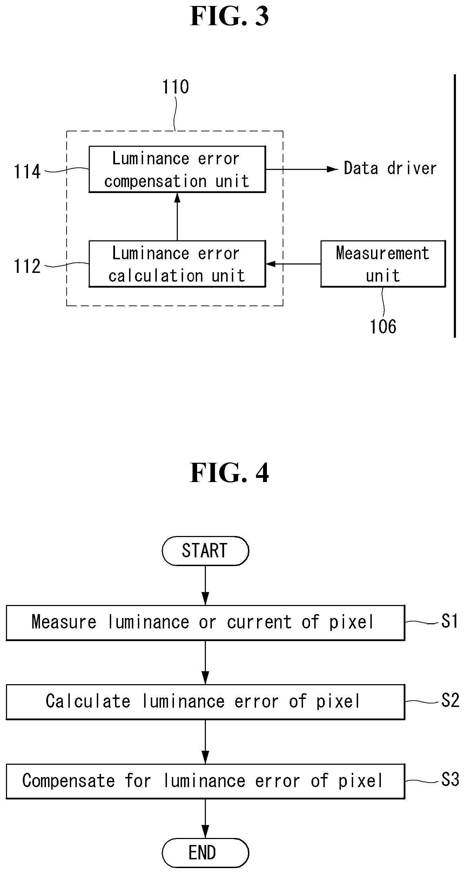

The timing controller 110 may include a self-calibration device shown in FIG. 3. The timing controller 110 calculates a luminance error of the pixel between gray levels using the self-calibration device based on a measured current value or a measured luminance value received from the measurement unit 106. The timing controller 110 adjusts the emission time of the subframe or performs the remapping of the subframes, thereby compensating for the luminance error.

The host system may be implemented as one of a television system, a set-top box, a navigation system, a DVD player, a Blu-ray player, a personal computer (PC), a home theater system, and a phone system.

As shown in FIG. 2, each pixel includes a first TFT T1, a second TFT T2, a third TFT T3, an OLED, a storage capacitor C, and the like.

The first TFT T1 is turned on in response to the scan pulse from the first scan line 12a. The first TFT T1 is a switching element supplying the data voltage DATA to a gate of the second TFT T2 in response to the scan pulse.

The second TFT T2 is connected between a power line, to which a high potential power voltage ELVDD is supplied, and the OLED and supplies the current to the OLED depending on the data voltage DATA applied to the gate of the second TFT T2. The second TFT T2 is a driving element that makes the OLED emit light depending on the data voltage DATA.

The third TFT T3 is turned on in response to the erase pulse from the second scan line 12b and discharges a gate voltage of the second TFT T2 up to a predetermined bias voltage Vbias. The bias voltage Vbias may be a low potential power voltage VSS. The third TFT T3 is a switching element forming a gate discharge path of the second TFT T2 in response to the erase pulse.

The storage capacitor C holds a gate-to-source voltage Vgs of the second TFT T2. The storage capacitor C holds the gate voltage of the second TFT T2 and maintains the emission of the OLED.

The OLED may be configured so that organic compound layers including a hole injection layer HIL, a hole transport layer HTL, an emission layer EML, an electron transport layer ETL, an electron injection layer EIL, etc. are stacked. The OLED emits light when electrons and holes are combined in the emission layer EML.

Each pixel of the display panel 100 may be configured as shown in FIG. 2, but the embodiment of the invention is not limited thereto. For example, each pixel may have any circuit configuration capable of being driven through the digital driving method. Each pixel may further include an internal compensation circuit. The internal compensation circuit includes at least one switching TFT and at least one capacitor. The internal compensation circuit initializes a gate of a driving TFT, senses a threshold voltage and a mobility of the driving TFT, and compensates for the data voltage DATA. The internal compensation circuit may use any known compensation circuit.

FIG. 3 shows the self-calibration device according to the embodiment of the invention. FIG. 4 is a flowchart showing a self-calibration method of the display device according to the embodiment of the invention.

Referring to FIGS. 3 and 4, the self-calibration device according to the embodiment of the invention includes the measurement unit 106, a luminance error calculation unit 112, and a luminance error compensation unit 114. The self-calibration device may be embedded in the timing controller 110, but the embodiment of the invention is not limited thereto. For example, the self-calibration device may be implemented as a separate circuit configuration.

The self-calibration method includes a step S1 of measuring a luminance or a current of the pixel, a step S2 of calculating a luminance error of the pixel, and a step S3 of compensating for the luminance error of the pixel.

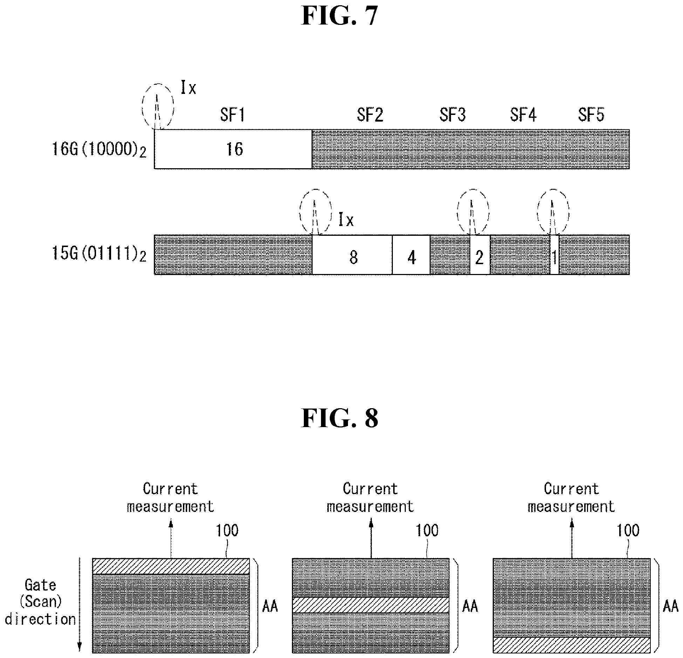

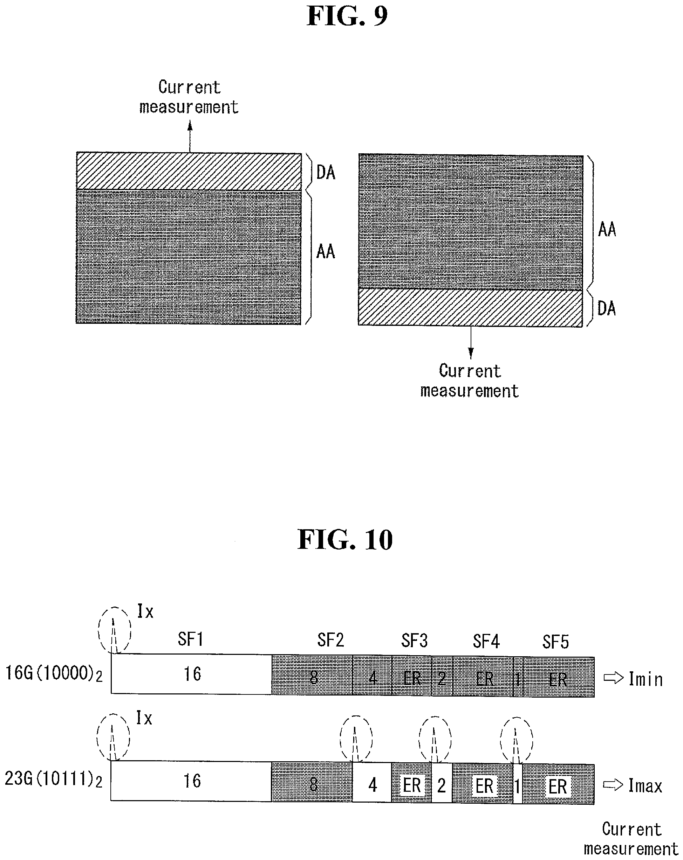

The luminance error calculation unit 112 analyzes the result of a luminance or current measurement received from the measurement unit 106 and calculates a luminance error of the pixel at each gray level. A cause of the luminance error is described in detail later with reference to FIG. 7. A method of calculating the luminance error is described in detail later with reference to FIG. 10.

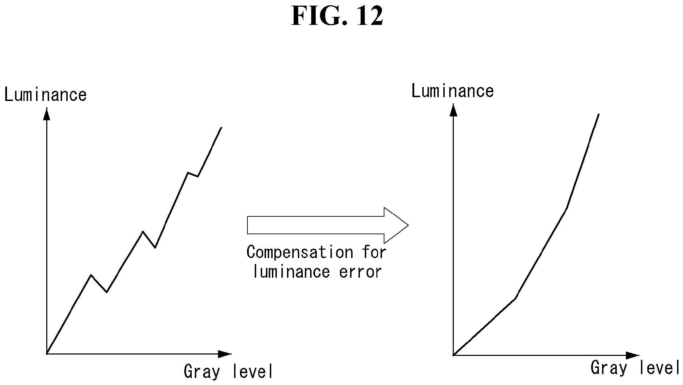

The luminance error compensation unit 114 receives the result of a calculation of the luminance error from the luminance error calculation unit 112. The luminance error compensation unit 114 adjusts an emission time of a sub frame, to which LSB of data is mapped, or performs the remapping of the subframes, thereby compensating for the luminance error. As a result, as shown in FIG. 12, a luminance of the pixel linearly or nonlinearly increases as the gray level increases.

The self-calibration device and the self-calibration method according to the embodiment of the invention may be performed in a driving time previously set in the display device. For example, the self-calibration device and the self-calibration method may be performed in a power-on sequence immediately after the display device is powered on, and in a power-off sequence immediately after the display device is powered off. Further, the self-calibration device and the self-calibration method according to the embodiment of the invention may measure the luminance or the current of the pixel in a vertical blank period, between two successively arranged frames, in which data is not input, and may measure the luminance or the current of the pixel at previously set time intervals.

Because the display device according to the embodiment of the invention compensates for a luminance error resulting from a rush current based on the result of a measurement of a luminance or a current of a pixel in each of display panels using the self-calibration device and the self-calibration method shown in FIGS. 3 and 4, the embodiment of the invention can adaptively compensate the luminance error suitably for each of the display panels.

FIG. 5 shows an example of a method for arranging subframes. FIG. 6 shows a method for mapping data to subframes in the subframe arrangement method shown in FIG. 5.

Referring to FIGS. 5 and 6, one frame period may be divided into first to fifth subframes SF1 to SF5. Each subframe may be subdivided into an address time t1 in which data is written on the pixels, an emission time t2 in which the pixels emit light, and an erase time t3 in which the pixels are turned off. The address time t1 for one line of the display panel 100 is one horizontal period. In one subframe (for example, the third subframe SF3), an address time t4, in which data is written on all of the lines of the display panel 100, is one vertical period. The timing controller 110 supplies the timing control signals to the data driver 102 and the gate driver 104 and controls timings of the address time t1, the emission time t2, and the erase time t3 of the subframe. In the example shown in FIG. 5, a length of the emission time t2 decreases to one half with the passage of time from the first subframe SF1 to the fifth subframe SF5. The erase time t3 is not assigned to the first and second subframes SF1 and SF2.

The first subframe SF1 includes an emission time representing a gray level of $2^4$ bits of data, and the second subframe SF2 includes an emission time representing a gray level of $2^3$ bits of data. The third subframe SF3 includes an emission time representing a gray level of $2^2$ bits of data, and the fourth subframe SF4 includes an emission time representing a gray level of $2^1$ bits of data. The fifth subframe SF5 includes an emission time representing a gray level of $2^0$ bit of data. 24-bit MSB of data is mapped to the first subframe SF1, and 4-bit ($2^3$ $2^2$ $2^1$ $2^0$) LSB of the data is mapped to the second to fifth subframes SF2 to SF5.

In the digital driving method, the data of the input image is mapped to the subframe on a per bit basis. The pixel is turned on or off depending on the gray level of the data on a per subframe basis. For example, when the gray level of the data is 16G(10000)$_2$, the pixels are turned on and emit light in the first subframe SF1, and the pixels are turned off in the remaining second to fifth subframes SF2 to SF5. Further, when the gray level of the data is 15G(01111)$_2$, the pixels do not emit light in the first subframe SF1, and the pixels emit light in the remaining second to fifth subframes SF2 to SF5. In FIG. 6, "○" indicates the subframe in which the pixels emit light, and "×"indicates the subframe in which the pixels do not emit light.

The method for arranging the subframes is not limited to FIG. 5. For example, the number of subframes assigned to one frame period or the emission time of the subframe may be variously changed.

The method for arranging the subframes according to the embodiment of the invention adjusts the emission time of the subframe or performs the remapping of the subframes depending on the application of the self-calibration method.

FIG. 7 shows an example where a luminance error of a pixel occurs due to a rush current of the pixel.

In the digital driving method, a plurality of subframes are assigned to one frame period, and a large number of switching operations (or a large number of transitions) of the pixel is generated in one frame period. When the pixel is converted from an off-state to an on-state, a rush current occurs in the pixel. The rush current is a current instantaneously and strongly generated when the pixel in the off-state is turned on. Because the rush current is instantaneously and strongly generated in the initial stage of the subframe, the rush current leads to the luminance error of the pixel. In FIG. 7, "Ix" indicates the rush current of the pixel. The rush current instantaneously increases a luminance of the pixel to a value greater than the luminance represented by a gray level, leading to the luminance error or a luminance reversal between gray levels. The luminance reversal between the gray levels is a phenomenon, in which a luminance a low gray level represents is higher than a luminance a high gray level represents. The digital driving method of an organic light emitting diode (OLED) display has many advantages, but the luminance error or the luminance reversal problem resulting from the rush current of the pixel need to be solved so as to further improve image quality of the OLED display.

In a voltage driving method of the OLED display, there is no switching operation of the pixel in one frame period and the current of the pixel is uniform. Therefore, the luminance error resulting from the rush current is scarcely generated. In a plasma display panel (PDP), gray levels are represented through the digital driving method. However, because the pixel is maintained in a plasma state after an address discharge writing data on the pixel and before a sustain period, the rush current is not generated in the pixel. Accordingly, because the rush current of the pixel in the voltage driving method of the OLED display and the digital driving method of the PDP scarcely affects the image quality, the problem of the rush current can be neglected.

Because the current flowing in the OLED of the pixel is proportional to the luminance of the pixel, the luminance error may be calculated by measuring the current of the pixel. Because there is a difference between driving characteristics of the display panels, the measurement unit 106 measures a current of a pixel generated by really driving pixels (or dummy pixels). As shown in FIG. 8, the measurement unit 106 may supply the gate pulse to at least one of gate lines of a pixel array AA, on which an image is displayed, and may supply the data voltage to the pixel through the digital driving method, thereby measuring a current of one or more pixels. Alternatively, the measurement unit 106 may measure the current through average values of several lines of the entire screen.

The measurement unit 106 may measure the current from the dummy pixel positioned in a non-display area so that the screen is not turned on. A structure of the dummy pixel is substantially the same as the structure of the pixel of the pixel array, and the dummy pixel is formed in the display panel 100. As shown in FIG. 9, the dummy pixel is formed in a non-display area DA outside the pixel array AA, on which the input image is displayed, and is covered so that a user cannot see it. In the non-display area DA one can measure the current indirectly by using similar stressed pixels in DA without light emission in active area AA. The current or luminance might be measured in the pixel area AA for design-oriented displays which does not allow large bezel.

The measurement unit 106 measures a current Imin when a minimum number of switching operations of the pixel through the digital driving method is generated in one frame period, and measures a current Imax when a maximum number of switching operations of the pixel through the digital driving method is generated in one frame period.

The minimum switching current Imin of the pixel is a current measured when the pixel emits light in only one subframe period of one frame period so that the minimum number of switching operations of the pixel is generated in one frame period. The luminance error resulting from a rush current Ix may be seen as a noise. Thus, the minimum switching current Imin of the pixel is a current of the pixel measured when a signal-to-noise ratio (SNR) is large. In an example shown in FIG. 10, the minimum switching current Imin of the pixel was measured when the pixel emits light only in the first subframe SF1 and is maintained in a turn-off state in the remaining subframes.

The maximum switching current Imax of the pixel is a current measured when the pixel emits light in a plurality of subframe periods so that the maximum number of switching operations of the pixel is generated in one frame period. The maximum switching current Imax of the pixel may be measured when the signal-to-noise ratio is small. However, the maximum switching current Imax of the pixel is measured to reflect a measured value of a real luminance error in a subframe having a relatively short emission time. In the example shown in FIG. 10, when the pixel emits light in a first subframe SF1, is turned off in a second subframe SF2, and emits light in all of subframes SF3, SF4, and SF5 to which an erase period ER is assigned, the maximum number of switching operations of the pixel is generated in one frame period. In this state, the maximum switching current Imax of the pixel is measured.

FIG. 10 shows an example of a current measuring method of the pixel and a calculating method of the luminance error.

Referring to FIG. 10, the luminance error calculation unit 112 calculates an average value Ix_avg of the rush current Ix based on the minimum switching current Imin of the pixel and the maximum switching current Imax of the pixel received from the measurement unit 106.

"Imin" is a current of the pixel measured at a gray level of $16G(10000)_2$, and "Imax" is a current of the pixel measured at a gray level of $23G(10111)_2$. A current flowing in the OLED of the pixel at each gray level is previously determined. It is assumed that the current of the pixel at each gray level is "I_1G = 10nA, I_2G = 20nA, ..., I_pG = p*10 nA". An example of a method for calculating the average value Ix_avg of the rush current Ix is described below.

$$\text{Imax} - \text{Imin} = \text{I\_7G} + (3*\text{Ix}) \qquad ..... \qquad (1)$$

In the above Equation (1), because "I_7G" is a current of 7G (= 23G - 16G), I_7G is 70 nA. "3*Ix" is a value obtained by subtracting the number (= once) of times the rush current occurs at a gray level of $16G(10000)_2$ from the number (= four times) of times the rush current occurs at a gray level of $23G(10111)_2$. In the above Equation (1), because Imax, Imin, and I_7G are known values, the rush current Ix can be calculated. The rush current Ix calculated through the above Equation (1) is referred to as "Ix1".

$$\text{Imax} + \text{Imin} = \text{I\_39G} + (5*\text{Ix}) \qquad ..... \qquad (2)$$

In the above Equation (2), because "I_39G" is a current of 39G (= 23G + 16G), I_39G is 390 nA. "5*Ix" is a value obtained by adding the number (= four times) of times the rush current occurs at a gray level of $23G(10111)_2$ to the number (= once) of times the rush current occurs at a gray level of $16G(10000)_2$. In the above Equation (2), because Imax, Imin, and I_39G are known values, the rush current Ix can be calculated. The rush current Ix calculated through the above Equation (2) is referred to as "Ix2".

The luminance error calculation unit 112 calculates the average value Ix_avg of the rush current Ix using an average value (= (Ix1+Ix2)/2) of Ix1 and Ix2. The current flowing in the OLED of the pixel is proportional to the luminance of the pixel. Thus, the embodiment of the invention may convert the average value Ix_avg calculated by the luminance error calculation unit 112 into the luminance of the pixel and may quantitatively decide an average value of the luminance error resulting from the rush current Ix based on the average value Ix_avg. Hence, the embodiment of the invention may quantitatively calculate the luminance error resulting from the rush current at each gray level based on the luminance error caused when the rush current Ix is generated once.

The luminance error compensation unit 114 reflects the luminance error received from the luminance error calculation unit 112 and reduces the emission time of the sub frame or performs the remapping of the subframes.

A method for reducing the emission time of the subframe reduces the luminance of the subframe by a luminance increase in the average value Ix_avg. The method fixes an emission time of a MSB subframe having a relatively long emission time and reduces an emission time of a LSB subframe having a relatively short emission time by the luminance increase in the average value Ix_avg.

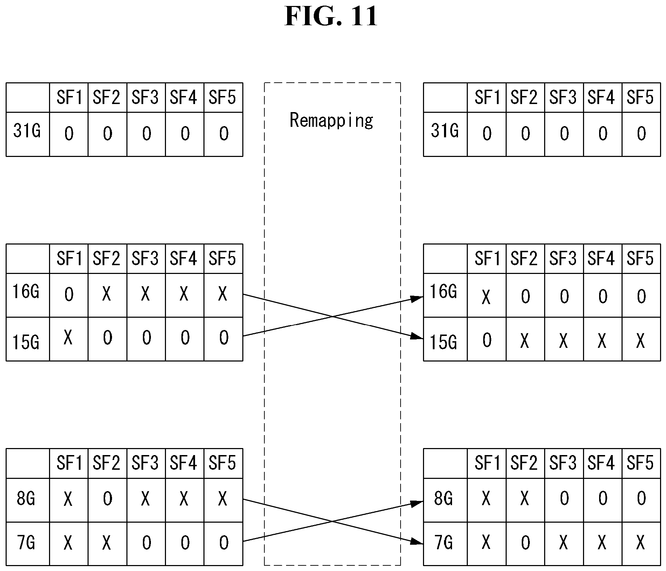

The remapping of the subframes changes values of gray levels, in which the luminance reversal is generated, and switches between the values of the gray levels of the data at the gray levels, in which the luminance reversal is generated. For example, as shown in FIG. 11, when the luminance reversal is generated at gray levels $15G(01111)_2$ and $16G(10000)_2$ due to the luminance error, the luminance error compensation unit 114 changes the gray level $16G(10000)_2$ of data of the input image to $15G(01111)_2$ and changes the gray level $15G(01111)_2$ of data of the input image to $16G(10000)_2$. When the values of the gray levels of the data are changed, there occurs a change in the subframe, which is turned on in the mapping process of the subframes. Therefore, the luminance of the pixel changes.

As a result, as shown in FIG. 12, because the emission times of the gray levels, in which the luminance reversal is generated, are reversed, the luminance reversal problem is solved.

The embodiment of the invention described the method for measuring the current of the pixel to estimate the luminance error, but is not limited thereto. For example, the embodiment of the invention may measure the luminance of the pixel and may compensate the luminance error of the pixel based on the result of a measurement. The embodiment of the invention described the method for measuring the currents Imin and Imax and calculating the average value of the currents Imin and Imax so as to increase the accuracy of the method for measuring the current of the pixel, but is not limited thereto. The embodiment of the invention may estimate the luminance error of the pixel resulting from the rush current using only the current Imin even if the accuracy is reduced.

As described above, the embodiment of the invention compensates for the luminance error resulting from the rush current based on the result of a measurement of the luminance or the current of the pixel of each display panel in the display device driven using the digital driving method. Therefore, the embodiment of the invention can adaptively compensate the luminance error suitably for each display panel.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

**Claims**

1. An OLED display device, wherein the OLED display device is configured to be driven by controlling emission times of a pixel depending on gray levels of data of an input image by dividing one frame period into a plurality of subframe periods (SF), separating data of the input image on a per bit basis, mapping the separated data of the input image to the subframe periods (SF), and turning on or off of the pixel on a per subframe basis for representing gray levels of the input image, the display device comprising a self-calibration device for self-calibrating the OLED display device by compensating for a luminance error resulting from a rush current Ix, the rush current Ix being a current instantaneously and strongly generated when the pixel in an off-state is turned on, wherein the self-calibrating device comprises:

   a measurement unit (106) configured to measure a current or luminance of a pixel for one frame period, wherein the measurement unit (106) is further configured to drive the pixel with a predetermined gray level having a predetermined number of turning on-operations of the pixel in the one frame period;
   a luminance error calculation unit (112) configured to calculate the rush current Ix of the pixel emitting light based on the measured current or luminance value of the pixel and a predetermined current of the pixel at each gray level and to calculate a luminance error of the pixel based on the rush current; and
   a luminance error compensation unit (114) configured to reduce an emission time of a subframe period or change a turned-on subframe period in the mapping of the separated data of an input image to the subframe periods to compensate the calculated luminance error,
   wherein in changing the turned-on subframe period in the mapping of the separated data of the input image to the subframe periods the luminance error compensation unit (114) is adapted to switch values of gray levels of data at gray levels, in which a luminance reversal of the gray levels occurs due to the luminance error of the pixel,
   wherein in the OLED display device the luminance reversal of a gray level occurs when the rush current Ix causes the luminance of a pixel for said gray level to be greater than the luminance of the pixel for a higher gray level.

2. The display device of claim 1, wherein the luminance error compensation unit (114) is adapted to reduce an emission time (t2) of a subframe period (SF), to which least significant bit (LSB) of data to be written on the pixel will be mapped.

3. The display device as claimed in any of the preceding claims, wherein the measurement unit (106) is adapted to measure at least one of a current, as a minimum switching current Imin, when a minimum number of switching operations of the pixel is generated in one frame period, and a current, as a maximum switching current (Imax), when a maximum number of switching operations of the pixel is generated in one frame period.

4. The display device of claim 3, wherein the luminance error calculation unit (112) is adapted to calculate an average value Ix_avg of the rush current Ix based on the minimum switching current Imin and the maximum switching current Imax and to calculate the luminance error of the pixel based on the average value of the rush current.

5.  The display device as claimed in any of the preceding claims, wherein the display device includes a time controller (110) adapted to control a data driver and a gate driver (102, 104) .

6.  The display device as claimed in any of the preceding claims, wherein the measurement unit (106) includes a luminance sensor or a current sensor for measuring the luminance or current of a pixel respectively.

7.  The display device as claimed in any of the preceding claims, wherein the measurement unit (106) is adapted to measure current of one or more pixels located on a display area (AA) of the display panel (100) and/or is adapted to measure a current of one or more pixels located in a non-display area (DA) of the display panel (100).

8.  The display device as claimed in any of the preceding claims, wherein the measurement, calculation and compensation of luminance error are performed during a power-on sequence immediately after the display device is powered on, and/or during a power-off sequence immediately after the display device is powered off.

9.  A self-calibration method of an OLED display device, wherein the OLED display device is configured to be driven by controlling emission times of a pixel depending on gray levels of data of an input image by dividing one frame period into a plurality of subframe periods, separating data of the input image on a per bit basis, mapping the separated data of the input image to the subframe periods (SF), and turning on or off of the pixel on a per subframe basis for representing gray levels of the input image, the self-calibration method comprising:

    measuring (S1) a current or luminance of a pixel for one frame period,
    wherein measuring (S1) the current or luminance level of the pixel further comprises driving the pixel with a predetermined gray level having a predetermined number of turning on-operations in the one frame period;
    calculating the rush current Ix of the pixel emitting light based on the measured current or luminance value of the pixel and a predetermined current of the pixel at each gray level, and calculating (S2) a luminance error of the pixel based on the rush current, the rush current Ix being a current instantaneously and strongly generated when a pixel in an off-state is turned on; and
    reducing (S3) an emission time (t2) of a subframe period (SF) or changing a turned-on subframe period in the mapping of the separated data of the input image to the subframe periods to compensate the calculated luminance error,
    wherein in changing the turned-on subframe period in the mapping of the separated data of the input image to the subframe periods the compensating for the luminance error of the pixel includes switching values of gray levels of data at gray levels, in which a luminance reversal of the gray levels occursdue to the luminance error of the pixel,
    wherein in the OLED display device the luminance reversal of a gray level occurs when the rush current Ix causes the luminance of a pixel for said gray level to be greater than the luminance of the pixel for a higher gray level.

10. The self-calibration method of claim 9, wherein the compensating for the luminance error of the pixel includes reducing an emission time of a subframe period, to which least significant bit (LSB) of data to be written on the pixel will be mapped.

**Patentansprüche**

1.  OLED-Anzeigevorrichtung, wobei die OLED-Anzeigevorrichtung konfiguriert ist, durch das Steuern von Aussendungszeiten eines Pixels abhängig von Graustufen von Daten eines Eingangsbildes durch Teilen einer Rahmenperiode in mehrere Unterrahmenperioden (SF), Trennen von Daten des Eingangsbildes auf einer Pro-Bit-Basis, Abbilden der getrennten Daten des Eingangsbildes auf die Unterrahmenperioden (SF) und Ein- oder Ausschalten des Pixels auf einer Pro-Unterrahmen-Basis zum Repräsentieren von Graustufen des Eingangsbildes angesteuert zu werden, wobei die Anzeigevorrichtung eine Selbstkalibrierungsvorrichtung zum Selbstkalibrieren der OLED-Anzeigevorrichtung durch Kompensieren eines Helligkeitsfehlers, der sich aus einem Anstiegsstrom Ix ergibt, umfasst, wobei der Anstiegsstrom Ix ein Strom ist, der sofort und stark erzeugt wird, wenn das Pixel in einem Auszustand eingeschaltet wird, wobei die Selbstkalibrierungsvorrichtung Folgendes umfasst:

    eine Messeinheit (106), die konfiguriert ist, einen Strom oder eine Helligkeit eines Pixels für eine Rahmenperiode zu messen, wobei die Messeinheit (106) ferner konfiguriert ist, das Pixel mit einer vorbestimmten Graustufe mit einer vorbestimmten Anzahl von Einschaltvorgängen des Pixels in der einen Rahmenperiode anzusteuern; eine Helligkeitsfehlerberechnungseinheit (112), die konfiguriert ist, den Anstiegsstrom Ix des Pixels, das Licht aussendet, anhand des gemessenen Strom- oder Helligkeitswerts des Pixels und eines vorbestimmten Stroms des Pixels bei jeder Graustufe zu berechnen und einen Helligkeitsfehler des Pixels anhand des Anstiegsstroms zu berechnen; und

eine Helligkeitsfehlerkompensationseinheit (114), die konfiguriert ist, eine Aussendungszeit einer Unterrahmenperiode zu verringern oder eine eingeschaltete Unterrahmenperiode in der Abbildung der getrennten Daten des Eingangsbildes auf die Unterrahmenperioden zu ändern, um den berechneten Helligkeitsfehler zu kompensieren,

wobei beim Ändern der eingeschalteten Unterrahmenperiode in der Abbildung der getrennten Daten des Eingangsbildes auf die Unterrahmenperioden die Helligkeitsfehlerkompensationseinheit (114) ausgelegt ist, Werte von Graustufen von Daten bei Graustufen, in denen eine Helligkeitsumkehrung von Graustufen aufgrund des Helligkeitsfehlers des Pixels auftritt, zu wechseln,

wobei in der OLED-Anzeigevorrichtung die Helligkeitsumkehrung von Graustufen auftritt, wenn der Anstiegsstrom Ix bewirkt, dass die Helligkeit eines Pixels für die Graustufe größer als die Helligkeit des Pixels für eine höhere Graustufe ist.

2. Anzeigevorrichtung nach Anspruch 1, wobei die Helligkeitsfehlerkompensationseinheit (114) ausgelegt ist, eine Aussendungszeit (t2) einer Unterrahmenperiode (SF), auf die das niedrigstwertige Bit (LSB) von Daten, die auf das Pixel zu schreiben sind, abgebildet wird, zu verringern.

3. Anzeigevorrichtung nach einem der vorhergehenden Ansprüche, wobei die Messeinheit (106) ausgelegt ist, einen Strom als einen minimalen Wechselstrom Imin zu messen, wenn eine minimale Anzahl von Wechselvorgängen der Pixel in einer Rahmenperiode erzeugt wird, und einen Strom als einen maximalen Wechselstrom (Imax) zu messen, wenn eine maximale Anzahl von Wechselvorgängen des Pixels in einer Rahmenperiode erzeugt wird.

4. Anzeigevorrichtung nach Anspruch 3, wobei die Helligkeitsfehlerberechnungseinheit (112) ausgelegt ist, einen Mittelwert Ix_avg des Anstiegsstroms Ix anhand des minimalen Wechselstroms Imin und des maximalen Wechselstroms Imax zu berechnen und den Helligkeitsfehler des Pixels anhand des Mittelwerts des Anstiegsstroms zu berechnen.

5. Anzeigevorrichtung nach einem der vorhergehenden Ansprüche, wobei die Anzeigevorrichtung eine Zeitsteuereinheit (110) enthält, die ausgelegt ist, einen Datentreiber und einen Gate-Treiber (102, 104) zu steuern.

6. Anzeigevorrichtung nach einem der vorhergehenden Ansprüche, wobei die Messeinheit (106) einen Helligkeitssensor oder einen Stromsensor jeweils zum Messen der Helligkeit oder des Stroms eines Pixels enthält.

7. Anzeigevorrichtung nach einem der vorhergehenden Ansprüche, wobei die Messeinheit (106) ausgelegt ist, einen Strom eines oder mehrerer Pixel, die sich auf einem Anzeigebereich (AA) der Anzeigetafel (100) befinden, zu messen, und/oder ausgelegt ist, einen Strom eines oder mehrerer Pixel, die sich in einem Nicht-Anzeigebereich (DA) der Anzeigetafel (100) befinden, zu messen.

8. Anzeigevorrichtung nach einem der vorhergehenden Ansprüche, wobei die Messung, Berechnung und Kompensation des Helligkeitsfehlers während einer Einschaltsequenz, unmittelbar nachdem die Anzeigevorrichtung eingeschaltet worden ist, und/oder während einer Ausschaltsequenz, unmittelbar nachdem die Anzeigevorrichtung ausgeschaltet worden ist, ausgeführt werden.

9. Selbstkalibrierungsverfahren einer OLED-Anzeigevorrichtung, wobei die OLED-Anzeigevorrichtung konfiguriert ist, durch Steuern von Ausendungszeiten eines Pixels abhängig von Graustufen von Daten eines Eingangsbildes durch Teilen einer Rahmenperiode in mehrere Unterrahmenperioden, Trennen der Daten des Eingangsbildes auf einer Pro-Bit-Basis, Abbilden der getrennten Daten des Eingangsbildes auf die Unterrahmenperioden (SF) und Ein- oder Ausschalten des Pixels auf einer Pro-Unterrahmen-Basis zum Repräsentieren von Graustufen des Eingangsbildes angesteuert zu werden, wobei das Selbstkalibrierungsverfahren Folgendes umfasst:

Messen (S1) eines Stroms oder einer Helligkeit eines Pixels für eine Rahmenperiode,
wobei das Messen (S1) des Stroms oder des Helligkeitspegels des Pixels ferner umfasst, das Pixel mit einer vorbestimmten Graustufe mit einer vorbestimmten Anzahl von Einschaltvorgängen in der einen Rahmenperiode anzusteuern;

Berechnen des Anstiegsstroms Ix des Pixels, das Licht aussendet, anhand des gemessenen Strom- oder Helligkeitswerts des Pixels und eines vorbestimmten Stroms des Pixels bei jeder Graustufe und Berechnen (S2) eines Helligkeitsfehlers des Pixels anhand des Anstiegsstroms, wobei der Anstiegsstrom Ix ein Strom ist, der sofort und stark erzeugt wird, wenn ein Pixel in einem Auszustand eingeschaltet wird; und

Verringern (S3) einer Aussendungszeit (t2) einer Unterrahmenperiode (SF) oder Ändern einer eingeschalteten Unterrahmenperiode in der Abbildung der getrennten Daten des Eingangsbildes auf die Unterrahmenperioden, um den berechneten Helligkeitsfehler zu kompensieren,

wobei beim Ändern der eingeschalteten Unterrahmenperiode in der Abbildung der getrennten Daten des Eingangsbildes auf die Unterrahmenperioden das Kompensieren des Helligkeitsfehlers des Pixels enthält, Werte von Graustufen von Daten bei Graustufen, in denen eine Helligkeitsumkehrung von Graustufen aufgrund des Helligkeitsfehlers des Pixels auftritt, zu wechseln,

wobei in der OLED-Anzeigevorrichtung die Helligkeitsumkehrung einer Graustufe auftritt, wenn der Anstiegsstrom Ix bewirkt, dass die Helligkeit eines Pixels für die Graustufe größer als die Helligkeit des Pixels für eine höhere Graustufe ist.

**10.** Selbstkalibrierungsverfahren nach Anspruch 9,
wobei das Kompensieren des Helligkeitsfehlers des Pixels enthält, eine Aussendungszeit einer Unterrahmenperiode, auf die das niedrigstwertige Bit (LSB) von Daten, die auf das Pixel zu schreiben sind, abgebildet wird, zu verringern.

## Revendications

**1.** Dispositif d'affichage à OLED, dans lequel le dispositif d'affichage à OLED est conçu pour être entraîné par des temps d'émission de commande d'un pixel selon des niveaux de gris de données d'une image d'entrée par la division d'une période de trame en une pluralité de périodes sous-trame (SF), la séparation de données de l'image d'entrée bit par bit, le mappage des données séparées de l'image d'entrée en des périodes de sous-trame (SF), et l'allumage ou l'arrêt du pixel sous-trame par sous-trame destiné à la représentation des niveaux de gris de l'image d'entrée, le dispositif d'affichage comprenant un dispositif d'auto-calibrage destiné à l'auto-calibrage du type d'affichage à OLED à l'aide de la compensation d'une erreur de luminance provenant d'un courant d'appel Ix, le courant d'appel Ix étant un courant produit de manière instantanée et fortement lorsque le pixel dans un état éteint est allumé, dans lequel le dispositif d'auto-calibrage comprend :

une unité de mesure (106) conçue pour mesurer un courant ou luminance d'un pixel pendant une période de trame, dans lequel l'unité de mesure (106) est en outre conçue pour entraîner le pixel avec un niveau de gris prédéterminé ayant un nombre prédéterminé d'opérations d'allumage du pixel pendant l'unique période de trame ;

une unité de calcul d'erreur de luminance (112) conçue pour calculer le courant d'appel Ix de la lumière émettant un pixel en fonction de la valeur du courant ou de luminance mesurée du pixel et d'un courant prédéterminé du pixel à chaque niveau de gris et pour calculer une erreur de luminance du pixel en fonction du courant d'appel ; et

une unité de compensation d'erreur de luminance (114) conçue pour réduire un temps d'émission d'une période de sous-trame ou pour changer une période allumée de sous-trame lors du mappage des données séparées d'une image d'entrée en des périodes de sous-trame pour compenser l'erreur de luminance calculée,

dans lequel lors du changement de la période allumée de sous-trame lors du mappage des données séparées de l'image d'entrée en des périodes de sous-trame, l'unité de compensation d'erreur de luminance (114) est conçue pour commuter des valeurs de niveaux de gris de données à des niveaux de gris, dans lequel une inversion de luminance des niveaux de gris se produit du fait de l'erreur de luminance du pixel,

dans lequel dans le dispositif d'affichage à OLED, l'inversion de luminance d'un niveau de gris se produit lorsque le courant d'appel Ix amène la luminance d'un pixel pour ledit niveau de de gris à devenir plus importante que la luminance du pixel pour un niveau de gris plus élevé.

**2.** Dispositif d'affichage selon la revendication 1, dans lequel l'unité de compensation d'erreur de luminance (114) est conçue pour réduire un temps d'émission (t2) d'une période de sous-trame (SF), auquel le bit le moins significatif (LSB) de données devant être écrites sur le pixel sera mappé.

**3.** Dispositif d'affichage selon l'une quelconque des revendications précédentes, dans lequel l'unité de mesure (106) est conçue pour mesurer au moins l'un parmi un courant, comme courant de commutation minimum Imin, lorsqu'un nombre minimum d'opérations de commutation du pixel est produit lors d'une période de trame, et un courant, comme courant de commutation maximum (Imax), lorsqu'un nombre maximum d'opérations de commutation du pixel est produit lors d'une période de trame.

4. Dispositif d'affichage selon la revendication 3, dans lequel l'unité de calcul d'erreur de luminance (112) est conçue pour calculer une valeur moyenne Ix_avg du courant d'appel Ix en fonction du courant de commutation minimum Imin et du courant de commutation maximum Imax et pour calculer l'erreur de luminance pixel en fonction de la valeur moyenne du courant d'appel.

5. Dispositif d'affichage selon l'une quelconque des revendications précédentes, dans lequel le dispositif d'affichage comprend un contrôleur temporel (110) conçu pour commander un pilote de données et un pilote de grille (102, 104).

6. Dispositif d'affichage selon l'une quelconque des revendications précédentes, dans lequel l'unité de mesure (106) comprend un capteur de luminance ou un capteur de courant destiné à la mesure de la luminance ou du courant d'un pixel, respectivement.

7. Dispositif d'affichage selon l'une quelconque des revendications précédentes, dans lequel l'unité de mesure (106) est conçue pour mesurer le courant d'un ou de plusieurs pixels situés sur une zone d'affichage (AA) du panneau d'affichage (100) et/ou est conçue pour mesurer un courant d'un ou de plusieurs pixels situés dans une zone de non-affichage (DA) du panneau d'affichage (100).

8. Dispositif d'affichage selon l'une quelconque des revendications précédentes dans lequel la mesure, le calcul et la compensation d'erreur de luminance sont réalisés pendant une séquence de mise sous tension immédiatement après que le dispositif d'affichage a été mis sous tension, et/ou pendant une séquence de mise hors tension immédiatement après que le dispositif a été mis hors tension.

9. Procédé d'auto-calibrage d'un dispositif d'affichage à OLED, dans lequel le dispositif d'affichage à OLED est conçu pour être entraîné par des temps d'émission de commande d'un pixel selon des niveaux de gris de données d'une image d'entrée par la division d'une période de trame en une pluralité de périodes sous-trame, la séparation de données de l'image d'entrée bit par bit, le mappage des données séparées de l'image d'entrée en des périodes de sous-trame (SF), et l'allumage ou l'arrêt du pixel sous-trame par sous-trame destiné à la représentation des niveaux de gris de l'image d'entrée, le procédé d'auto calibrage comprenant :

la mesure (S1) d'un courant ou d'une luminance d'un pixel pendant une période de trame,
dans lequel la mesure (S1) du niveau de courant ou de luminance du pixel comprend en outre l'entraînement du pixel avec un niveau de gris prédéterminé ayant un nombre prédéterminé d'opérations d'allumage lors d'une période de trame ;
le calcul du courant d'appel Ix de la lumière émettant un pixel en fonction de la valeur du courant ou de luminance mesurée du pixel et d'un courant prédéterminé du pixel à chaque niveau de gris, et le calcul (S2) d'une erreur de luminance du pixel en fonction du courant d'appel, le courant d'appel Ix étant un courant produit de manière instantanée et fortement lorsqu'un pixel dans un état éteint est allumé ; et
la réduction (S3) d'un temps d'émission (t2) d'une période de sous-trame (SF) ou le changement d'une période allumée de sous-trame lors du mappage des données séparées de l'image d'entrée en des périodes de sous-trame pour compenser l'erreur de luminance calculée,
dans lequel lors du changement de la période allumée de sous-trame lors du mappage des données séparées de l'image d'entrée en des périodes de sous-trame, la compensation pour l'erreur de luminance du pixel comprend la commutation de valeurs de niveaux de gris de données à des niveaux de gris, dans lequel une inversion de luminance des niveaux de gris se produit du fait de l'erreur de luminance du pixel,
dans lequel dans le dispositif d'affichage à OLED l'inversion de luminance d'un niveau de gris se produit lorsque le courant d'appel Ix amène la luminance d'un pixel pour ledit niveau de de gris à devenir plus importante que la luminance du pixel pour un niveau de gris plus élevé.

10. Procédé d'auto-calibrage selon la revendication 9, dans lequel la compensation pour l'erreur de luminance du pixel comprend la réduction d'un temps d'émission d'une période de sous-trame, auquel le bit le moins significatif (LSB) de données devant être écrites sur le pixel sera mappé.

# FIG. 1

# FIG. 2

# FIG. 3

110

114 — Luminance error compensation unit → Data driver

112 — Luminance error calculation unit ← Measurement unit

106

# FIG. 4

START

Measure luminance or current of pixel —— S1

Calculate luminance error of pixel —— S2

Compensate for luminance error of pixel —— S3

END

# FIG. 5

# FIG. 6

| | SF1 | SF2 | SF3 | SF4 | SF5 |
|---|---|---|---|---|---|
| 16G $(10000)_2$ | 0 | X | X | X | X |
| 15G $(01111)_2$ | X | 0 | 0 | 0 | 0 |

# FIG. 7

# FIG. 8

# FIG. 9

# FIG. 10

# FIG. 11

|     | SF1 | SF2 | SF3 | SF4 | SF5 |
|-----|-----|-----|-----|-----|-----|
| 31G | 0   | 0   | 0   | 0   | 0   |

Remapping

|     | SF1 | SF2 | SF3 | SF4 | SF5 |
|-----|-----|-----|-----|-----|-----|
| 31G | 0   | 0   | 0   | 0   | 0   |

|     | SF1 | SF2 | SF3 | SF4 | SF5 |
|-----|-----|-----|-----|-----|-----|
| 16G | 0   | X   | X   | X   | X   |
| 15G | X   | 0   | 0   | 0   | 0   |

|     | SF1 | SF2 | SF3 | SF4 | SF5 |
|-----|-----|-----|-----|-----|-----|
| 16G | X   | 0   | 0   | 0   | 0   |
| 15G | 0   | X   | X   | X   | X   |

|    | SF1 | SF2 | SF3 | SF4 | SF5 |
|----|-----|-----|-----|-----|-----|
| 8G | X   | 0   | X   | X   | X   |
| 7G | X   | X   | 0   | 0   | 0   |

|    | SF1 | SF2 | SF3 | SF4 | SF5 |
|----|-----|-----|-----|-----|-----|
| 8G | X   | X   | 0   | 0   | 0   |
| 7G | X   | 0   | X   | X   | X   |

# FIG. 12

Luminance

Gray level

Compensation for
luminance error

Luminance

Gray level

**REFERENCES CITED IN THE DESCRIPTION**

**Patent documents cited in the description**

- KR 1020140190752
- US 20030122813 A1
- US 20030201727 A1
- JP 2011158821 A
- US 20110089853 A1